# EUROPÄISCHE PATENTANMELDUNG

(11) **EP 4 494 812 A1**
(43) Veröffentlichungstag der Anmeldung: **22.01.2025**
(21) Anmeldenummer: 23187027.0
(22) Anmeldetag: 21.07.2023
(51) Int. Cl.: B24B 7/17, B24B 7/22, B24B 37/04, B24B 37/08, B24B 37/10, H01L 21/02

(54) **VERFAHREN ZUR BEARBEITUNG VON HALBLEITERSCHEIBEN**

(71) Anmelder: Siltronic AG, 81677 München (DE)
(72) Erfinder: Oberhans, Stephan, 83370 Seeon (DE); Lehner, Rudolf, 83308 Trostberg (DE); Weindl, Katharina, 94166 Stubenberg (DE)

(57) **Zusammenfassung**

Verfahren zur Bearbeitung einer Halbleiterscheibe umfassend (in folgender Reihenfolge): (a) einen Schritt zum Beschichten einer ersten Seite der Halbleiterscheibe enthaltend einen Schritt zur Bildung einer Deckschicht einer Dicke d durch Aufbringen eines härtbaren Materials und Aushärten des Materials auf die erste Seite der Halbleiterscheibe; (b) das Montieren der Halbleiterscheibe auf einem Tisch einer Schleifvorrichtung, so dass eine Oberfläche der gehärteten Deckschicht an einer Referenzoberfläche des Tischs anliegt; (c) anschließendes Flachschleifen einer zweiten Seite der Halbleiterscheibe auf einer Rückseite der ersten Seite der Halbleiterscheibe mittels der Schleifvorrichtung; (d) einen Schritt zur Entfernung der gehärteten Deckschicht von der ersten Seite der Halbleiterscheibe; (e) einen zweiten Oberflächenschleifschritt der ersten Seite der Halbleiterscheibe; (f) das simultane beidseitige Schleifen der Halbleiterscheibe mit einem Schleifabtrag dadurch gekennzeichnet, dass die Dicke der Deckschicht kleiner ist als 40 µm, bevorzugt kleiner als 30 µm, besonders bevorzugt kleiner als 20 und größer als 10 µm, und der simultane doppelseitige Schleifschritt nach dem zweiten Oberflächenschleifschritt erfolgt.

## Beschreibung

Gegenstand der vorliegenden Erfindung ist ein Verfahren zur Bearbeitung von Scheiben aus Halbleitermaterial.

Für Elektronik, Mikroelektronik und Mikro-Elektromechanik werden als Ausgangsmaterialien Halbleiterscheiben (Substrate) mit extremen Anforderungen an globale und lokale Ebenheit, einseiten-bezogene lokale Ebenheit (Nanotopologie), Rauigkeit und Sauberkeit benötigt. Halbleiterscheiben sind Scheiben aus Halbleitermaterialien, insbesondere Verbindungshalbleiter wie Galliumarsenid oder Elementhalbleiter wie Silicium und Germanium.

Gemäß dem Stand der Technik werden Halbleiterscheiben in einer Vielzahl von aufeinander folgenden Prozessschritten hergestellt. Im Allgemeinen kann folgende Herstellungssequenz benutzt werden:
- Herstellen eines einkristallinen Halbleiterstabs (Kristallzucht),
- Zerteilen des Halbleiterstabs in einzelne Stabstücke,
- Auftrennen des Stabs in einzelne Scheiben (Innenloch- oder Drahtsägen),
- mechanische Bearbeitung der Scheiben (Läppen, Schleifen),
- chemische Bearbeitung der Scheiben (alkalische oder saure Ätze),
- chemo-mechanische Bearbeitung der Scheiben (Politur),
- optional weitere Beschichtungsschritte (z.B. Epitaxie, Temperaturbehandlung)

Die mechanische Bearbeitung der Halbleiterscheibe dient der Entfernung von Sägewelligkeiten, ferner dem Abtrag der durch die raueren Sägeprozesse kristallin geschädigten oder vom Sägedraht kontaminierten Oberflächenschichten und vor allem der globalen Einebnung der Halbleiterscheiben. Ferner dient die mechanische Bearbeitung der Halbleiterscheibe der Herstellung einer gleichmäßigen Dickenverteilung, d.h. dass die Halbleiterscheiben eine gleichmäßige Dicke haben.

Als Verfahren zur mechanischen Bearbeitung der Halbleiterscheiben sind das Läppen sowie das Oberflächen-Schleifen (einseitig, doppelseitig) bekannt.

Beim Einseitenschleifen wird die Halbleiterscheibe rückseitig auf einer Unterlage ("chuck") gehalten und vorderseitig von einer Topfschleifscheibe unter Drehung von Unterlage und Schleifscheibe und langsamer axialer bzw. radialer Zustellung eingeebnet. Verfahren und Vorrichtungen zum einseitigen Oberflächenschleifen einer Halbleiterscheibe sind beispielsweise aus der US 2008 021 40 94 A1 oder aus EP 0 955 126 A2 bekannt.

Beim simultanen Doppelseitenschleifen ("(simultaneous)-double-disc grinding", sDDG) wird die Halbleiterscheibe frei schwimmend zwischen zwei, auf gegenüberliegenden kollinearen Spindeln montierten Schleifscheiben gleichzeitig beidseitig bearbeitet und dabei weitgehend frei von Zwangskräften axial zwischen einem vorder- und rückseitig wirkenden Wasser- (hydrostatisches Prinzip) oder Luftkissen (aerostatisches Prinzip) geführt und radial lose von einem umgebenden dünnen Führungsring oder von einzelnen radialen Speichen am Davonschwimmen gehindert. Verfahren und Vorrichtungen zum simultanen doppelseitigen Oberflächenschleifen einer Halbleiterscheibe sind beispielsweise aus EP 0 755 751 A1**,** EP 0 971 398 A1**,** DE 10 2004 011 996 A1 sowie DE 10 2006 032 455 A1 bekannt.

Die US 2018/297 168 A1 offenbart ein Verfahren zur Herstellung von Halbleiterscheiben, wobei zuerst ein dünner scheibenartiger Wafer durch Schneiden eines Einkristalls aus Halbleitermaterial hergestellt wird, dann eine planarisierte Deckschicht durch Aufbringen eines härtbaren Materials auf die gesamte erste Oberfläche des Wafers gebildet wird (Deckschicht-Bildungsschritt), und dann die Deckschicht gehärtet wird (Deckschicht-Härtungsschritt). Als Nächstes wird eine zweite Wafer-Seite auf der Rückseite der ersten Oberfläche mittels einer Schleifvorrichtung flach geschliffen, dann wird die Deckschicht von der ersten Oberfläche des Wafers entfernt. Ferner wird die erste Oberfläche des Wafers mittels der Schleifvorrichtung flach geschliffen. Die Oberflächenhöhe der ersten Oberfläche des Wafers nach dem Schneideschritt und vor dem Deckschicht-Bildungsschritt wird einer Frequenzanalyse unterzogen, und, wenn die Amplitude der Oberflächenwellung der ersten Oberfläche des Wafers in einem Wellenlängenbereich von 10 bis 100 mm größer oder gleich 0,5 µm ist, werden der Deckschicht-Bildungsschritt und der Deckschicht-Härtungsschritt mehrere Male wiederholt.

Bei dem in US 2018/297 168 A1 beschriebenen Verfahren ist eine Dicke des härtbaren Materials, das auf die erste Oberfläche des Wafers während des Beschichtungsschritts aufgebracht wird, größer oder gleich 40 µm, ist jedoch kleiner als 300 µm.

Die Verwendung von solch dicken Schichten birgt das Risiko, dass die Oberfläche der aufgebrachten Schicht nicht ausreichend parallel mit der Oberfläche der Halbleiterscheibe ist, da offenbar das Auspolymerisieren des verwendeten Materials in der Regel zu einem Schrumpfen des Materials führt. Dies hat zur Folge, dass die Geometrie der Halbleiterscheibe nicht den gewünschten Erwartungen für höhere Qualitätsanforderungen entspricht.

Dies hat zur Folge, dass vereinfacht gesagt die lokale Ebenheit der Halbleiterscheibe verbessert, aber die globale Ebenheit der Halbleiterscheibe verschlechtert wird. In vielen Fällen ist es aber gerade wichtig, dass die Halbleiterscheiben neben einer guten lokalen Ebenheit auch eine gute globale Ebenheit aufweisen.

Aufgabe der vorliegenden Erfindung ist es, ein Verfahren bereitzustellen, das genau diese Eigenschaften bei den Halbleiterscheiben hervorruft.

Gelöst wird die Aufgabe durch die in den Ansprüchen beschriebenen Verfahren.

### Kurzbeschreibung der Figuren

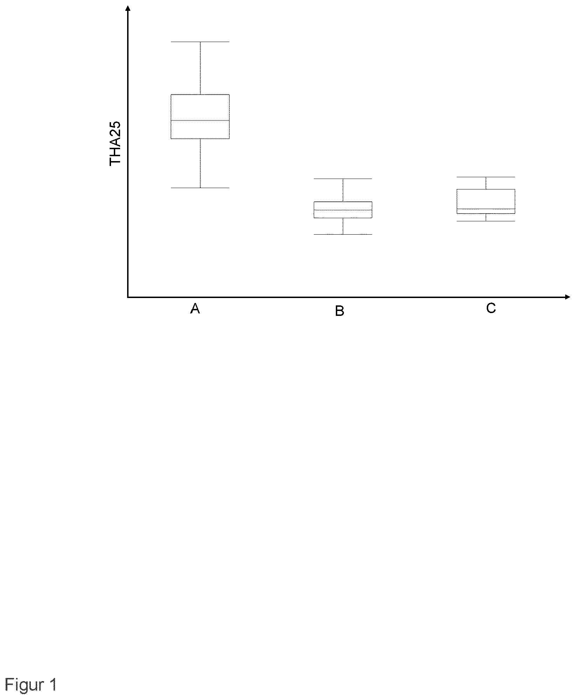

**Figur 1** zeigt die Verteilung der ermittelten THA25-Werte für drei verschiedene Versuchsbedingungen in relativen Einheiten. **A** repräsentiert Halbleiterscheiben, die lediglich ein Doppelseitenschleifen erfahren haben, **B** zeigt die Verteilung der Halbleiterscheiben, die mit einem Prozess behandelt wurden, der beispielsweise in US 2018/297 168 A1 beschrieben wurde. Hierbei wird auf das Doppelseitenschleifen verzichtet und gleichzeitig eine relativ Dicke Schicht an härtbarem Material verwendet. Die Dicke des härtbaren Materials betrug in diesem Fall 70 µm. Außerdem zeigt die Figur die THA25 Werte für nach dem erfinderischen Verfahren hergestellten Halbleiterscheiben **(C).** Man erkennt, dass die Gruppen von Halbleiterscheiben **B** und **C** sehr ähnliche Qualität in Bezug auf den Geometrieparameter THA25 aufweisen. Der Vorteil der Gruppe der Halbleiterscheiben **C** liegt in der kleineren Dicke der aushärtbaren Schicht und damit der geringeren Menge des zu verwendenden Epoxidharzes.

### Detaillierte Beschreibung erfindungsgemäßer Ausführungsbeispiele

Zur Beurteilung der Geometrie von Halbleiterscheiben gibt es viele genormte Messverfahren und Messmethoden. Die Erfinder beschränkten sich darauf die Halbleiterscheiben mittels der Parameter THA25 zu beurteilen.

Messmethode für **THA25:** Zur Untersuchung der Nanotopographie kann ein Interferometer, beispielsweise ein Gerät vom Typ WaferSight^{™} der KLA-Tencor Corp. verwendet werden. Ein solches Interferometer eignet sich zur Messung der Topographie auf der oberen Seitenfläche einer Halbleiterscheibe. Das Gerät bildet eine Höhenkarte der oberen Seitenfläche der Halbleiterscheibe ab, die gefiltert wird und über die ein Analysenfenster mit definierter Analysenfläche bewegt wird. Die Auswertung der Höhenunterschiede im Analysenfenster erfolgt durch THA (threshold height analysis) entsprechend der Normen SEMI M43-0418 und SEMI M78-0618 festgelegten Verfahrensvorschriften.

Das erfindungsgemäße Verfahren zur Bearbeitung einer Halbleiterscheibe umfasst die folgenden Arbeitsschritte:
Einen ersten Arbeitsschritt zum Beschichten einer ersten Seite der Halbleiterscheibe. Die Beschichtung wird ähnlich wie in US 2018/297 168 A1 beschrieben durchgeführt.

Erfindungsgemäß enthält dieser erste Arbeitsschritt einen **ersten Teilschritt** zur Bildung einer Deckschicht einer Dicke d durch Aufbringen eines härtbaren Materials und einen **zweiten Teilschritt** zum Aushärten des Materials auf die erste Seite der Halbleiterscheibe.

Das härtbare Material beinhaltet dabei bevorzugt **Epoxidharz.** Für die durchgeführten Experimente wurde das Epoxidharz "Resiflat103" der Firma Disco Corporation verwendet.

Die Dicke der Deckschicht **d** ist dabei erfindungsgemäß größer als 10 µm und kleiner als 40 µm, besonders bevorzugt kleiner als 30 µm und besonders bevorzugt kleiner als 20 µm.

Das erfindungsgemäße Verfahren enthält ferner einen **zweiten** Arbeitsschritt beinhaltend das Montieren der Halbleiterscheibe auf einem Tisch einer Schleifvorrichtung, so dass eine Oberfläche der gehärteten Deckschicht an einer Referenzoberfläche des Tischs anliegt.

Das erfindungsgemäße Verfahren enthält ferner einen **dritten** Arbeitsschritt zum Flachschleifen einer zweiten Seite der Halbleiterscheibe auf einer Rückseite der ersten Seite der Halbleiterscheibe mittels der Schleifvorrichtung.

Bevorzugt beträgt der Abtrag beim Flachschleifen der zweiten Seite der Halbleiterscheibe mehr als **20 µm** und weniger als **100 µm** beträgt, besonders bevorzugt mehr als **30 µm** und weniger als **80 µm**.

Das erfindungsgemäße Verfahren enthält ferner einen **vierten** Arbeitsschritt zur Entfernung der gehärteten Deckschicht von der ersten Seite der Halbleiterscheibe.

Das erfindungsgemäße Verfahren enthält ferner einen **fünften** Arbeitsschritt zum zweiten Schleifen der ersten Seite der Halbleiterscheibe.

Bevorzugt beträgt der Schleifabtrag beim zweiten Schleifen mehr als **20 µm** und weniger als **100 µm.**

Das erfindungsgemäße Verfahren enthält ferner einen **sechsten** Arbeitsschritt zum simultan beidseitigen Schleifen der Halbleiterscheibe mit einem Schleifabtrag.

Der Schleifabtrag bei diesem simultanen beidseitigen Schleifen beträgt dabei bevorzugt mehr als **10 µm** und weniger als **40 µm,** besonders bevorzugt weniger als **30 µm** und mehr als **15 µm**.

Bevorzugt erfolgt nach dem simultanen doppelseitigen Schleifschritt ein Ätzschritt, besonders bevorzugt beträgt dabei der Ätzabtrag mehr als 10 µm und weniger als 40 µm, ganz besonders bevorzugt mehr als 15 µm und weniger als 35 µm.

Bevorzugt erfolgt nach dem simultanen doppelseitigen Schleifschritt ein doppelseitiger Polierschritt, bei dem beide Seiten der Halbleiterscheibe simultan poliert werden, besonders bevorzugt findet dieser Polierschritt nach dem Ätzschritt statt.

Die ermittelten THA25-Werte sind hierfür in Figur 1 dargestellt.

Erfindungsgemäß findet der simultane doppelseitige Schleifschritt (sechster Arbeitsschritt) nach dem zweiten Oberflächenschleifschritt statt (fünfter Arbeitsschritt).

## Patentansprüche

1. Verfahren zur Bearbeitung einer Halbleiterscheibe umfassend (in folgender Reihenfolge):
(a) einen Schritt zum Beschichten einer ersten Seite der Halbleiterscheibe enthaltend
einen Schritt zur Bildung einer Deckschicht einer Dicke d durch Aufbringen eines härtbaren Materials und Aushärten des Materials auf die erste Seite der Halbleiterscheibe;
(b) das Montieren der Halbleiterscheibe auf einem Tisch einer Schleifvorrichtung, so dass eine Oberfläche der gehärteten Deckschicht an einer Referenzoberfläche des Tischs anliegt;
(c) anschließendes Flachschleifen einer zweiten Seite der Halbleiterscheibe auf einer Rückseite der ersten Seite der Halbleiterscheibe mittels der Schleifvorrichtung;
(d) einen Schritt zur Entfernung der gehärteten Deckschicht von der ersten Seite der Halbleiterscheibe;
(e) einen zweiten Oberflächenschleifschritt der ersten Seite der Halbleiterscheibe;
(f) das simultane beidseitige Schleifen der Halbleiterscheibe mit einem Schleifabtrag **dadurch gekennzeichnet, dass**
die Dicke der Deckschicht d kleiner ist als 40 µm, bevorzugt kleiner als 30 µm, besonders bevorzugt kleiner als 20 und größer als 10 µm,
und der simultane doppelseitige Schleifschritt nach dem zweiten Oberflächenschleifschritt erfolgt.

2. Verfahren nach Anspruch 1, **dadurch gekennzeichnet, dass** der Schleifabtrag beim simultanen beidseitigen Schleifen kleiner ist als 40 µm und größer ist als 10 µm.

3. Verfahren nach Anspruch 1 oder Anspruch 2, **dadurch gekennzeichnet, dass** der Abtrag beim Flachschleifen der ersten Seite der Halbleiterscheibe mehr als 20 µm und weniger als 100 µm beträgt.

4. Verfahren nach einem der vorigen Ansprüche, **dadurch gekennzeichnet, dass** der Abtrag beim Flachschleifen der zweiten Seite der Halbleiterscheibe mehr als 20 µm und weniger als 100 µm beträgt.

5. Verfahren nach einem der vorigen Ansprüche, **dadurch gekennzeichnet, dass** nach dem simultanen doppelseitigen Schleifschritt ein Ätzschritt erfolgt, wobei der Abtrag mehr als 10 µm und weniger als 40 µm beträgt.

6. Verfahren nach einem der vorigen Ansprüche, **dadurch gekennzeichnet, dass** nach dem simultanen doppelseitigen Schleifschritt ein doppelseitiger Polierschritt erfolgt, bei dem beide Seiten der Halbleiterscheibe simultan poliert werden.

7. Verfahren nach Anspruch 5, **dadurch gekennzeichnet, dass** nach dem Ätzschritt ein doppelseitiger Polierschritt erfolgt, bei dem beide Seiten der Halbleiterscheibe simultan poliert werden.
